# EUROPEAN PATENT SPECIFICATION

(11) **EP 2 130 940 B1**
(45) Date of publication and mention of the grant of the patent: **05.04.2017**
(21) Application number: 08009925.2
(22) Date of filing: 30.05.2008
(51) Int. Cl.: C23C 14/24

(54) **Arrangement and method for removing alkali- or alkaline earth-metals from a vacuum coating chamber**
Anordnung und Verfahren zum Entfernen von Alkali- oder Alkaline-Erdmetallen aus einer Vakuumbeschichtungskammer
Agencement et procédé pour supprimer des métaux alcalins ou alcalinoterreux d'une chambre de revêtement sous vide

(43) Date of publication of application: 09.12.2009
(73) Proprietor: Applied Materials, Inc., Santa Clara, CA 95054 (US)
(72) Inventor: Bangert, Stefan, 36396 Steinau (DE); Dieguez-Campo, José Manuel, 63457 Hanau (DE); König, Michael, 60529 Frankfurt am Main (DE); Krishna, Nety M., Sunnyvale, CA 94087 (US); Kwak, Byung-Sung Leo, Portland, OR 97229 (US)
(74) Representative: Zimmermann & Partner Patentanwälte mbB

(56) References cited:
- EP-A- 0 441 368
- JP-A- 2002 206 160
- JP-A- 2003 229 365
- US-A- 5 055 169
- US-A1- 2002 185 067
- US-A1- 2007 163 617

## Description

The invention relates to an arrangement and a method according to the preambles of claims 1 and 10.

Modem lithium batteries are, as a rule, produced in a vacuum chamber, wherein a substrate is provided with a lithium layer. The lithium layer is formed, for example, through the deposition on the substrate of lithium in the vapor state. Since lithium is highly reactive, contact by the operating personnel after opening the vacuum chamber must be avoided. Even if the excess lithium has been pumped out of the vacuum chamber, it is still possible for lithium particles deposited on the inner wall of the vacuum chamber or on facings and/or maskings to harm the operating personnel.

Methods for the production of lithium batteries are already known in which lithium is converted in a vacuum chamber into vapor, which is subsequently deposited on a substrate (JP 59-060866, JP 2003-007290, JP 2003-234100, JP 2007-207663). Nothing is found in these publications regarding the cleaning of the vacuum chamber.

It is further known to eliminate undesirable depositions on the inside of a coating installation by means of a cleaning gas (JP 2003-229365). However, lithium or alkali metals are herein not listed.

Furthermore, cleaning a process chamber by means of a gas containing 02 is known (US 2007/0163617 A1). Herein the cleaning is carried out at increased temperature and under vacuum. The gas preferably also contains H radicals, since the cleaning process can also be carried out by means of a plasma. However, the walls of the process chamber are cleaned of tungsten and not of lithium or another aggressive material.

A further method for cleaning coating chambers is disclosed in DE 103 38 275 A1. In this method the process chamber is flushed with a conditioned purge gas before a coating process. The purge gas is preferably comprised of O₂ and N₂ with a humidity value of maximally 30%.

The coating chamber is cleaned before the coating process and the coating material is not lithium.

US 2002/0185067 A1 discloses a device and a method for the *in situ* cleaning of a throttle valve in a CVD system. Here a cleaning gas is introduced which can comprise F₂, C₂F₆, O₂ or NF₃. Lithium is not discussed.

A cleaning process for a coating chamber is furthermore known in which *inter alia* N₂ and O₂ are employed as cleaning gases (EP 1 612 857 Al). These gases are converted to plasma and subsequently serve for cleaning the inner wall of a CVD chamber. High frequency is utilized for the generation of the plasma. However, not Li, but rather Si₃N₄ or SiO₂ are removed.

EP 0 441 368 A discloses a device and a method for eliminating excess material from a PVD chamber. During a cleaning cycle a vacuum is generated in the PVD chamber and a gas mixture with reactive gas is introduced into the PVD chamber. The reactive gas is herein activated through plasma discharge. The objects of the cleaning are also screenings. The eliminated material is Ti, W or Al, not however Li.

JP 2002-206160 discloses an apparatus for manufacturing a thin film of lithium metal or lithium alloy. To remove the lithium metal adhering to the inner wall of the apparatus, a heater is provided to melt the lithium metal adhering to the inner wall. By melting and removing the lithium metal adhering to the apparatus, the danger of ignition and explosion resultant from the reaction of the lithium metal with moisture when the apparatus is opened to the atmospheric air can be avoided.

The invention addresses the problem of cleaning such parts of a vacuum coating chamber which during the production of thin-film batteries are unintentionally coated, for example maskings, metal lining sheets and the like.

This problem is solved according to the characteristics of claims 1 and 10.

The advantage attained with the invention comprises in particular that unintentionally coated parts are cleaned in simple manner and the cycle times or service times are shortened. Since the cleaning can also be carried out cyclically, it is possible to operate a coating installation without interruption.

The invention consequently relates to a cleaning method in which from a vacuum coating chamber of a coating installation for the coating of substrates with alkali- or alkaline earth-metals, residues of alkali or alkaline earth-metals are removed. For this purpose into the chamber a gas from the group of N₂, O₂ or air is introduced which reacts with the alkali- or alkaline earth-metals to form the corresponding solid compounds. Water can still also be additionally introduced into the vacuum coating chamber.

After the alkali- or alkaline earth-metals have reacted with the gas, the corresponding solid compound is removed from the vacuum coating chamber.

An embodiment example of the invention is shown in the drawing and will be described in further detail in the following. In the drawing depict:

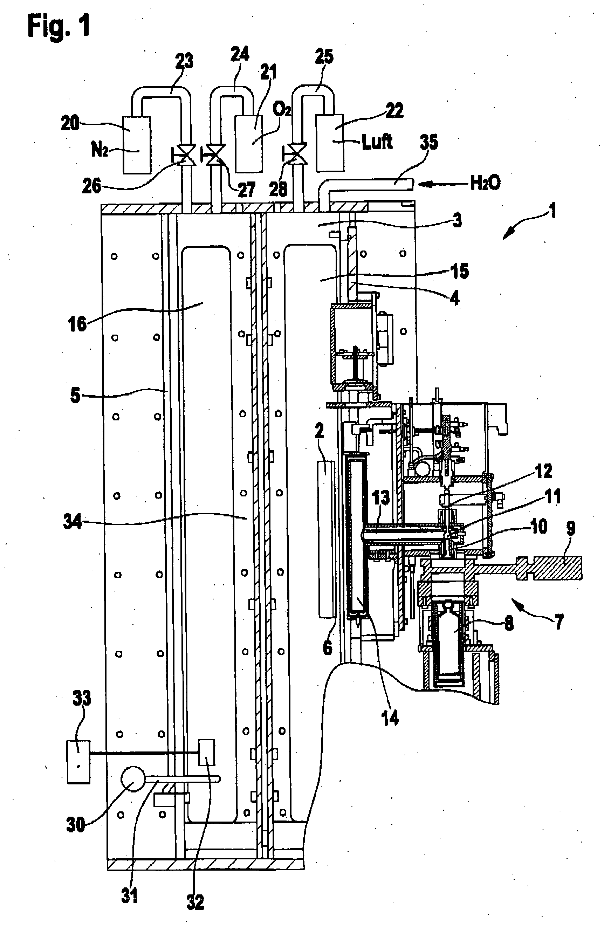

- Fig. 1: a vacuum chamber for coating a substrate by means of a vaporized material.

A coating installation 1, in which a substrate 2 can be coated, is shown in Figure 1 in sectional view. This coating installation 1 includes a vacuum coating chamber 3, of which two side-walls 4, 5 are evident. Masking 6 is disposed between the substrate 2 and a vapor feed system 7, which comprises a vaporizer crucible 8, a valve 9 and a vapor inlet 10 to 13. The end of the vapor inlet is formed by a linear distributor 14 implemented as a vertically oriented tube with linearly disposed openings. These openings are located opposite the masking 6. By 15, 16 are denoted covers in the vacuum chamber 3.

In the vaporizer crucible 8 is melted, for example, lithium for the production of thin-film lithium batteries and vaporized. Instead of lithium, another reactive metal from the group of alkali- and alkaline earth-metals, for example cesium, could also be utilized.

The vaporized material arrives via the vapor inlet 10 to 13 at the distributor 14 and from here, via the masking 6, which does not need to be provided in every case, at the substrate 2. In addition, the vaporized material also reaches the covers 15, 16 and other parts which it is not intended to reach.

When the coating of substrate 2 is completed, the unintentionally coated parts must be freed of the coating in order for the operating personnel not to be harmed by the reactive lithium when opening the vacuum chamber 3 and removing the coated substrate 2.

However, in order for a person not to come into contact with the lithium or other alkaline earth- or alkali-metals, these metals must be removed from the installation. The removal of these reactive metals from the installation takes place after the coating process has been terminated and the substrates have been transferred from the coating installation 1 via a vacuum lock, not shown in Figure 1. After the substrates have been removed from the coating installation 1, one or several gases are introduced into the vacuum chamber 3 before the opening the vacuum chamber 3.

For this purpose, outside of vacuum chamber 3 several gas containers 20, 21, 22 are provided which contain the gases N₂, O₂ or air. Activation of the gases is not absolutely required. These gas tanks 20, 21, 22 are connected via supply pipes 23, 24, 25 and valves 26, 27, 28 with the vacuum chamber 3. If N₂ is introduced into the vacuum chamber 3, the N₂ molecules combine with lithium according to the equation 6 Li + N₂ → 2 Li₃N. This end product is a solid which falls from the vertical surfaces to the bottom of the vacuum chamber 3 or adheres at the site of the reaction.

If O₂ is introduced into the vacuum chamber 3, based on the expression 4 Li + O₂ the colorless powdery solid compound Li₂O is formed, which is also nontoxic and falls from vertical parts.

It is understood that instead of pure oxygen, air can also be introduced into the vacuum chamber 3. This air can herein be enriched with O₂. Since air contains both nitrogen as well as also oxygen, lithium consequently reacts with the nitrogen as well as also with the oxygen. It is here advantageous if the air has a certain humidity. To this end the air can additionally be enriched with water. If there is also water contained in the air, the following reaction takes place:

Li + H₂O → LiOH + ½ H₂.

When air and water are introduced, in addition to Li₃N and Li₂O, LiOH and Li₂CO₃ are also formed.
For instance, Li₂CO₃ is formed through the following reaction: 2 LiOH + CO₂ → Li₂CO₃ + H₂O.
At high temperatures Li₂CO₃ breaks down again into Li₂O and CO₂. The same applies also to LiOH which breaks down into Li₂O and H₂O. The lithium compounds must in every case be nontoxic and remain stable in air.

Since the reactions of H₂O, O₂ and N₂ are exothermic, it is advantageous to cool the vacuum chamber 3. This can be carried out by means of a cooling system, not depicted in Figure 1.
In principle, the metal Li, or also the other alkali- and alkaline earth-metals, can be made to react with other substances, such as, for example, with halogens or hydrogen compounds of these halogens.
However, since these halogens or halogen compounds are highly reactive and can also chemically attack the chamber, it is necessary when employing these compounds to build the chamber of a material that is chemically inert relative to these compounds.

Although activation of the gases is not absolutely required, it is nevertheless advantageous to carry out the reaction at increased temperatures. A temperature in the range from 30° C up to 200° C can be selected, at which the reaction is started. It is obvious that at higher temperatures the reaction proceeds faster. It is of advantage if the reaction takes place at a pressure of up to 100 mbar. The choice of temperature as well as of pressure depends substantially on the design of the vacuum chamber 3. If only pure oxygen is utilized as the gas, the temperature can be, for example, 80° C and the pressure of the oxygen 100 mbar. This ensures optimal reaction conditions.
It is advantageous if during the cleaning process the reaction is monitored by means of a gas sensor 32. A gas sensor 32 to be considered is, for example, a mass spectrometer, a lambda probe or an IR or NIR spectrometer. Via these measuring devices the gas composition can be determined during the process. If a lambda probe is employed, oxygen is preferably added to the gas or gas mixture. In this case the oxygen content can be determined during the process. As long as there is still lithium in the chamber and reacts with the gases, the concentration of the reactive gases is below the concentration of the gases before their introduction into the vacuum chamber 3 vitiated with lithium. As soon as the lithium has reacted with the gases, the concentration of the gases reaches the starting value again. This indicates that the reaction process has been completed. The gas composition, which had been determined by means of the gas sensor 32, is supplied to an evaluation instrument 33. When the process is completed, by means of a pump 30 and an extraction fitting 31 the powder on the bottom of the vacuum chamber 3 can be suctioned out. It is also possible to vent the vacuum chamber 3 and subsequently to remove the powder by means of a dust extractor. It is herein advantageous to remove the lithium salt adhering on the walls of the vacuum chamber 3 by means of ultrasound such that it falls to the bottom. This facilitates the cleaning work considerably. By setting parameters such as, for example, pressure, temperature or the moisture content in the form of water in the gas or the gas mixture, the reaction with the lithium can be accelerated. In order to enrich gases with moisture, water is introduced into the vacuum chamber 3 via a feed pipe 35.

Whether the lithium salts remain adhered to the surface after the cleaning process or spall off and consequently fall to the bottom of the vacuum chamber 3 depends substantially on the layer thicknesses of the formed lithium salts. If the lithium layers formed in the coating reaction are very thin, salts with a very small grain diameter are formed in the cleaning process. Such lithium layers remain preferably well adhered on the walls of the vacuum chamber 3. If during the coating process thick lithium layers have been formed on the walls of the vacuum chamber, layers are formed in the cleaning reaction with the gases, which layers are under mechanical stress, which can lead to the spalling of the coating. For this reason it can be advantageous to remove the salt residues still adhering on the walls of the vacuum chamber 3 by means of ultrasound.

## Claims

1. Arrangement for removing alkali- or alkaline earth-metals from a vacuum coating chamber (3) of a coating installation (1) with at least one gas tank (20 - 22) connected via a supply pipe (23 - 25) with the vacuum coating chamber (3), which gas tank contains a gas from the group N₂, O₂ or air, wherein the vacuum coating chamber (3) includes at the bottom an extraction fitting (31) which is connected to a pump (30) or wherein the vacuum coating chamber (3) includes a dust extractor.

2. Arrangement as claimed in claim 1, **characterized in that** between the at least one gas tank (20 - 22) and the vacuum coating chamber (3) a valve (26 - 28) is provided.

3. Arrangement as claimed in claim 1, **characterized in that** the vacuum coating chamber (3) includes a feed pipe (35) for H₂O, via which H₂O can be introduced into the vacuum coating chamber (3).

4. Arrangement as claimed in claim 1, **characterized in that** the vacuum coating chamber (3) includes means with which the vacuum coating chamber (3) can be exposed to ultrasound.

5. Arrangement as claimed in claim 1, **characterized in that** the vacuum coating chamber (3) includes at least one gas sensor (32).

6. Arrangement as claimed in claim 5, **characterized in that** the gas sensor (32) is a mass spectrometer.

7. Arrangement as claimed in claim 5, **characterized in that** the gas sensor (32) is a lambda probe.

8. Arrangement as claimed in claim 5, **characterized in that** the gas sensor (32) is an IR or NIR spectroscope.

9. Arrangement as claimed in claim 1, **characterized in that** the metal is lithium.

10. Method for removing alkali- or alkaline earth-metals from a vacuum coating chamber (3) of a coating installation (1), **characterized by** the following steps:
a) the vacuum coating chamber (3) is set under vacuum after the coating process has been completed,
b) a gas from the group of N₂, O₂ or air is introduced into the vacuum coating chamber (3) such that the gas reacts with the alkali- or alkaline earth-metals in the vacuum coating chamber (3) and forms a solid compound,
c) the solid compound is removed from the vacuum coating chamber (3).

11. Method as claimed in claim 10, **characterized in that** the metal is lithium.

12. Method as claimed in claim 10, **characterized in that** H₂O is additionally introduced into the vacuum coating chamber (3).

13. Method as claimed in claim 10, **characterized in that** the air is enriched with O₂.

14. Method as claimed in claim 10, **characterized in that** the gas content during the reaction is determined by means of a gas sensor (32).

15. Method as claimed in claim 14, **characterized in that** the gas content is determined by means of a mass spectrometer.

16. Method as claimed in claim 14, **characterized in that** the oxygen content is determined by means of a lambda probe.

17. Method as claimed in claim 10, **characterized in that** at the beginning of the process a temperature of 30°C up to 200° C is set.

18. Method as claimed in claim 17, **characterized in that** the temperature is 80° C.

19. Method as claimed in claim 10, **characterized in that** a pressure of 100 mbar is set.

20. Method as claimed in claim 10, **characterized in that** the solid compound is removed from the vacuum coating chamber (3) by means of an extraction fitting (31) connected to a pump (30).

21. Method as claimed in claim 10, **characterized in that** the solid compound is removed from the vacuum coating chamber (3) by means of a dust extractor.

22. Method as claimed in claim 20 or 21, **characterized in that** the solid compound formed is detached by means of ultrasound from the walls of the vacuum coating chamber (3) before being removed from the vacuum coating chamber (3).

23. Method as claimed in claim 14, **characterized in that** the gas content is determined by means of an IR or NIR spectroscope.

## Patentansprüche

1. Anordnung zum Beseitigen von Alkali- oder Erdalkalimetallen aus einer Vakuumbeschichtungskammer (3) einer Beschichtungsanlage (1) mit mindestens einem Gasbehälter (20 - 22), der über ein Versorgungsrohr (23 - 25) mit der Vakuumbeschichtungskammer (3) verbunden ist, welcher Gasbehälter ein Gas aus der Gruppe N₂, O₂ oder Luft enthält, wobei die Vakuumbeschichtungskammer (3) am Boden eine Extraktionsarmatur (31) umfasst, die an eine Pumpe (30) angeschlossen ist, oder wobei die Vakuumbeschichtungskammer (3) einen Staubabsauger umfasst.

2. Anordnung nach Anspruch 1, **dadurch gekennzeichnet, dass** zwischen dem mindestens einen Gasbehälter (20 - 22) und der Vakuumbeschichtungskammer (3) ein Ventil (26 - 28) vorgesehen ist.

3. Anordnung nach Anspruch 1, **dadurch gekennzeichnet, dass** die Vakuumbeschichtungskammer (3) ein Zufuhrrohr (35) für H₂O umfasst, über das H₂O in die Vakuumbeschichtungskammer (3) eingeleitet werden kann.

4. Anordnung nach Anspruch 1, **dadurch gekennzeichnet, dass** die Vakuumbeschichtungskammer (3) Einrichtungen umfasst, mit denen die Vakuumbeschichtungskammer (3) Ultraschall ausgesetzt werden kann.

5. Anordnung nach Anspruch 1, **dadurch gekennzeichnet, dass** die Vakuumbeschichtungskammer (3) mindestens einen Gassensor (32) umfasst.

6. Anordnung nach Anspruch 5, **dadurch gekennzeichnet, dass** es sich bei dem Gassensor (32) um ein Massenspektrometer handelt.

7. Anordnung nach Anspruch 5, **dadurch gekennzeichnet, dass** es sich bei dem Gassensor (32) um eine Lamdasonde handelt.

8. Anordnung nach Anspruch 5, **dadurch gekennzeichnet, dass** es sich bei dem Gassensor (32) um ein IR- oder NIR-Spektrometer handelt.

9. Anordnung nach Anspruch 1, **dadurch gekennzeichnet, dass** es sich bei dem Metall um Lithium handelt.

10. Verfahren zum Beseitigen von Alkali- oder Erdalkalimetallen aus einer Vakuumbeschichtungskammer (3) einer Beschichtungsanlage (1), **gekennzeichnet durch** die folgenden Schritte:
(a) die Vakuumbeschichtungskammer (3) wird unter Vakuum gesetzt, nachdem der Beschichtungsprozess abgeschlossen wurde,
(b) ein Gas aus der Gruppe aus N₂, O₂ oder Luft wird in die Vakuumbeschichtungskammer (3) eingeleitet, derart, dass das Gas mit den Alkali- oder Erdalkalimetallen in der Vakuumbeschichtungskammer (3) reagiert und eine feste Verbindung bildet,
(c) die feste Verbindung wird aus der Vakuumbeschichtungskammer (3) beseitigt.

11. Verfahren nach Anspruch 10, **dadurch gekennzeichnet, dass** es sich bei dem Metall um Lithium handelt.

12. Verfahren nach Anspruch 10, **dadurch gekennzeichnet, dass** zusätzlich H₂O in die Vakuumbeschichtungskammer (3) eingeleitet wird.

13. Verfahren nach Anspruch 10, **dadurch gekennzeichnet, dass** die Luft mit O₂ angereichert wird.

14. Verfahren nach Anspruch 10, **dadurch gekennzeichnet, dass** der Gasgehalt während der Reaktion mittels eines Gassensors (32) bestimmt wird.

15. Verfahren nach Anspruch 14, **dadurch gekennzeichnet, dass** der Gasgehalt mittels eines Massenspektrometers bestimmt wird.

16. Verfahren nach Anspruch 14, **dadurch gekennzeichnet, dass** der Sauerstoffgehalt mittels einer Lambdasonde bestimmt wird.

17. Verfahren nach Anspruch 10, **dadurch gekennzeichnet, dass** zu Beginn des Prozesses eine Temperatur von 30°C bis zu 200°C eingestellt wird.

18. Verfahren nach Anspruch 17, **dadurch gekennzeichnet, dass** die Temperatur 80°C beträgt.

19. Verfahren nach Anspruch 10, **dadurch gekennzeichnet, dass** ein Druck von 100 mbar eingestellt wird.

20. Verfahren nach Anspruch 10, **dadurch gekennzeichnet, dass** die feste Verbindung aus der Vakuumbeschichtungskammer (3) mittels einer Extraktionsarmatur (31) beseitigt wird, die an eine Pumpe (30) angeschlossen ist.

21. Verfahren nach Anspruch 10, **dadurch gekennzeichnet, dass** die feste Verbindung aus der Vakuumbeschichtungskammer (3) mittels eines Staubabsaugers beseitigt wird.

22. Verfahren nach Anspruch 20 oder 21, **dadurch gekennzeichnet, dass** die gebildete feste Verbindung mittels Ultraschall von den Wänden der Vakuumbeschichtungskammer (3) gelöst wird, bevor sie aus der Vakuumbeschichtungskammer (3) beseitigt wird.

23. Verfahren nach Anspruch 14, **dadurch gekennzeichnet, dass** der Gasgehalt mittels eines IR- oder NIR-Spektroskops bestimmt wird.

## Revendications

1. Agencement destiné à enlever des métaux alcalins ou alcalinoterreux d'une chambre de revêtement sous vide (3) d'une installation de revêtement (1) comprenant au moins un réservoir de gaz (20 - 22) connecté via un tuyau d'alimentation (23 - 25) à la chambre de revêtement sous vide (3), lequel réservoir de gaz contient un gaz issu du groupe N₂, O₂ ou de l'air, sachant que la chambre de revêtement sous vide (3) inclut au fond un raccord d'extraction (31) qui est connecté à une pompe (30) ou sachant que la chambre de revêtement sous vide (3) inclut un extracteur de poussières.

2. Agencement tel que revendiqué dans la revendication 1, **caractérisé en ce qu'**une vanne (26 - 28) est prévue entre l'au moins un réservoir de gaz (20 - 22) et la chambre de revêtement sous vide (3).

3. Agencement tel que revendiqué dans la revendication 1, **caractérisé en ce que** la chambre de revêtement sous vide (3) inclut un tuyau d'alimentation (35) pour H₂O, via lequel de l'H₂O peut être introduit dans la chambre de revêtement sous vide (3).

4. Agencement tel que revendiqué dans la revendication 1, **caractérisé en ce que** la chambre de revêtement sous vide (3) inclut des moyens avec lesquels la chambre de revêtement sous vide (3) peut être exposée à des ultrasons.

5. Agencement tel que revendiqué dans la revendication 1, **caractérisé en ce que** la chambre de revêtement sous vide (3) inclut au moins un capteur de gaz (32).

6. Agencement tel que revendiqué dans la revendication 5, **caractérisé en ce que** le capteur de gaz (32) est un spectromètre de masse.

7. Agencement tel que revendiqué dans la revendication 5, **caractérisé en ce que** le capteur de gaz (32) est une sonde lambda.

8. Agencement tel que revendiqué dans la revendication 5, **caractérisé en ce que** le capteur de gaz (32) est un spectroscope IR ou NIR.

9. Agencement tel que revendiqué dans la revendication 1, **caractérisé en ce que** le métal est du lithium.

10. Procédé destiné à enlever des métaux alcalins ou alcalinoterreux d'une chambre de revêtement sous vide (3) d'une installation de revêtement (1), **caractérisé par** les étapes suivantes :
a) la chambre de revêtement sous vide (3) est mise sous vide après que le processus de revêtement a été achevé,
b) un gaz issu du groupe N₂, O₂ ou de l'air est introduit dans la chambre de revêtement sous vide (3) de telle sorte que le gaz réagisse avec les métaux alcalins ou alcalinoterreux dans la chambre de revêtement sous vide (3) et forme un composé solide,
c) le composé solide est enlevé de la chambre de revêtement sous vide (3).

11. Procédé tel que revendiqué dans la revendication 10, **caractérisé en ce que** le métal est du lithium.

12. Procédé tel que revendiqué dans la revendication 10, **caractérisé en ce que** du H₂O est en outre introduit dans la chambre de revêtement sous vide (3).

13. Procédé tel que revendiqué dans la revendication 10, **caractérisé en ce que** l'air est enrichi d'O₂.

14. Procédé tel que revendiqué dans la revendication 10, **caractérisé en ce que** la teneur en gaz pendant la réaction est déterminée au moyen d'un capteur de gaz (32).

15. Procédé tel que revendiqué dans la revendication 14, **caractérisé en ce que** la teneur en gaz est déterminée au moyen d'un spectromètre de masse.

16. Procédé tel que revendiqué dans la revendication 14, **caractérisé en ce que** la teneur en oxygène est déterminée au moyen d'une sonde lambda.

17. Procédé tel que revendiqué dans la revendication 10, **caractérisé en ce qu'**au début du processus, une température de 30°C à 200°C est réglée.

18. Procédé tel que revendiqué dans la revendication 17, **caractérisé en ce que** la température est de 80°C.

19. Procédé tel que revendiqué dans la revendication 10, **caractérisé en ce qu'**une pression de 100 mbar est réglée.

20. Procédé tel que revendiqué dans la revendication 10, **caractérisé en ce que** le composé solide est enlevé de la chambre de revêtement sous vide (3) au moyen d'un raccord d'extraction (31) connecté à une pompe (30).

21. Procédé tel que revendiqué dans la revendication 10, **caractérisé en ce que** le composé solide est enlevé de la chambre de revêtement sous vide (3) au moyen d'un extracteur de poussières.

22. Procédé tel que revendiqué dans la revendication 20 ou 21, **caractérisé en ce que** le composé solide formé est détaché au moyen d'ultrasons depuis les parois de la chambre de revêtement sous vide (3) avant d'être enlevé de la chambre de revêtement sous vide (3).

23. Procédé tel que revendiqué dans la revendication 14, **caractérisé en ce que** la teneur en gaz est déterminée au moyen d'un spectroscope IR ou NIR.
